(19) Europäisches Patentamt
European Patent Office
Office européen des brevets

(11) **EP 1 746 071 A1**

(12) **DEMANDE DE BREVET EUROPEEN**

(43) Date de publication:
**24.01.2007 Bulletin 2007/04**

(51) Int Cl.:
***B81B 3/00*** *(2006.01)*

(21) Numéro de dépôt: **05106734.6**

(22) Date de dépôt: **22.07.2005**

(84) Etats contractants désignés:
**AT BE BG CH CY CZ DE DK EE ES FI FR GB GR HU IE IS IT LI LT LU LV MC NL PL PT RO SE SI SK TR**
Etats d'extension désignés:
**AL BA HR MK YU**

(71) Demandeur: **CSEM Centre Suisse d'Electronique et de Microtechnique SA Recherche et Développement 2007 Neuchâtel (CH)**

(72) Inventeurs:
• **Noell, Wilfried**
  **2000, Neuchâtel (CH)**
• **Overstolz, Thomas**
  **2000, Neuchâtel (CH)**
• **De Rooij, Nico F.**
  **2000, Neuchâtel (CH)**
• **Stanley, Ross**
  **1005, Lausanne (CH)**

(74) Mandataire: **GLN**
  **Rue du Puits-Godet 8a**
  **2000 Neuchâtel (CH)**

(54) **Micro-actuateur ayant des poutre comportant des segments courbes**

(57) L'invention concerne un micro-actuateur du type comportant un élément mobile (10) rattaché à une base fixe (14) par l'intermédiaire de poutres de suspension (12), et des moyens de commande (16) dudit élément mobile (10). Afin d'éviter la concentration de stress dans les poutres, celles-ci comportent au moins un segment courbe. De façon avantageuse, les poutres entourent l'élément mobile (10) et sont arrangées de manière symétrique dans le plan de ce dernier. Ledit segment est décrit par une fonction mathématique définie sur un intervalle fini, continûment différentiable en chaque point dudit intervalle.

Fig. 1

**Description**

L'invention se rapporte au domaine des MEMS, de l'anglais Micro Electro Mechanical Systems. Elle concerne, plus précisément, un micro-actuateur capable d'effectuer des mouvements de translation et de bascule ou une combinaison des deux.

Les micro-actuateurs de conception classique comportent généralement une partie centrale solidaire de deux poutres de torsion formant ensemble un axe de rotation. Sous l'effet d'une force, par exemple, électrostatique, la partie centrale tourne autour de cet axe jusqu'à ce que la force soit équilibrée par la torsion des poutres. Ce type d'actuateur est utilisé, par exemple, comme micro-miroir de balayage au sein d'un micro-dispositif optique. Il est fabriqué selon la technologie des MEMS, bien connue de l'homme de métier.

Dans un mode de fabrication connu sous l'appellation 'Bulk Micromachining' ou micro-usinage en volume, des plaquettes de silicium comportant une mince couche d'oxyde enterrée et une épaisse couche de silicium de surface, forment le matériau de base des MEMS. Toutefois, les coefficients de dilatation de l'oxyde et du silicium étant différents, des tensions peuvent apparaître et induire des déformations dans certains éléments des micro-systèmes. C'est le cas, particulièrement, pour le micro-actuateur du type comportant une partie centrale et deux poutres de torsion. Ces dernières absorbent une partie du stress et, étant très flexibles, se voilent de façon aléatoire, ce qui a pour effet un déplacement non contrôlé de la partie centrale. Comme la partie centrale elle-même peut également subir des déformations, l'ensemble du dispositif peut se trouver inutilisable.

La présente invention permet de remédier à cet inconvénient en proposant un micro-actuateur compact, d'une grande stabilité et dont l'élément mobile reste optiquement plat.

Plus précisément, l'invention concerne un micro-actuateur du type comportant un élément mobile rattaché à une base fixe par l'intermédiaire de poutres de suspension et des moyens de commande de l'élément mobile. Selon l'invention, les poutres comportent au moins un segment courbe.

Par ailleurs, les micro-actuateurs de conception classique, comportant deux poutres de torsion, n'effectuent que des mouvements simples de rotation autour de l'axe défini par les poutres. Le micro-actuateur selon l'invention est, en revanche, capable d'effectuer des mouvements d'une grande complexité. A cet effet, l'élément mobile est à symétrie centrale et les poutres de suspension sont au nombre minimum de trois.

D'autres caractéristiques et avantages de l'invention apparaîtront à la lecture de la description qui suit, faite en regard du dessin annexé, dans lequel :

- les figures 1, 2 et 3 sont respectivement une vue en trois dimensions, une vue éclatée et une vue en coupe du micro-actuateur, et

- la figure 4 est une représentation de la fonction mathématique décrivant l'un des segments de ses poutres.

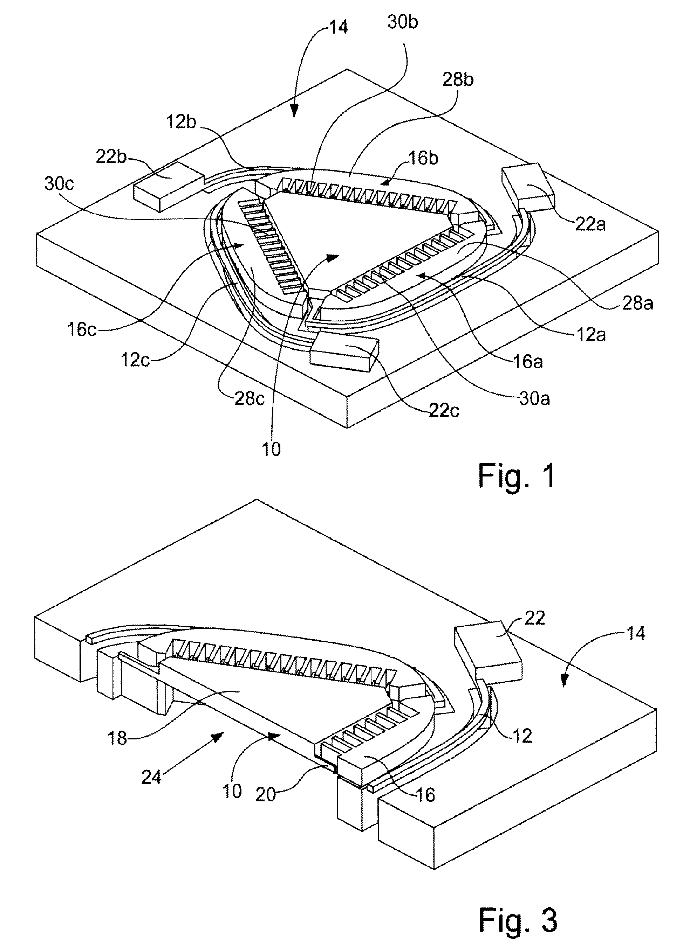

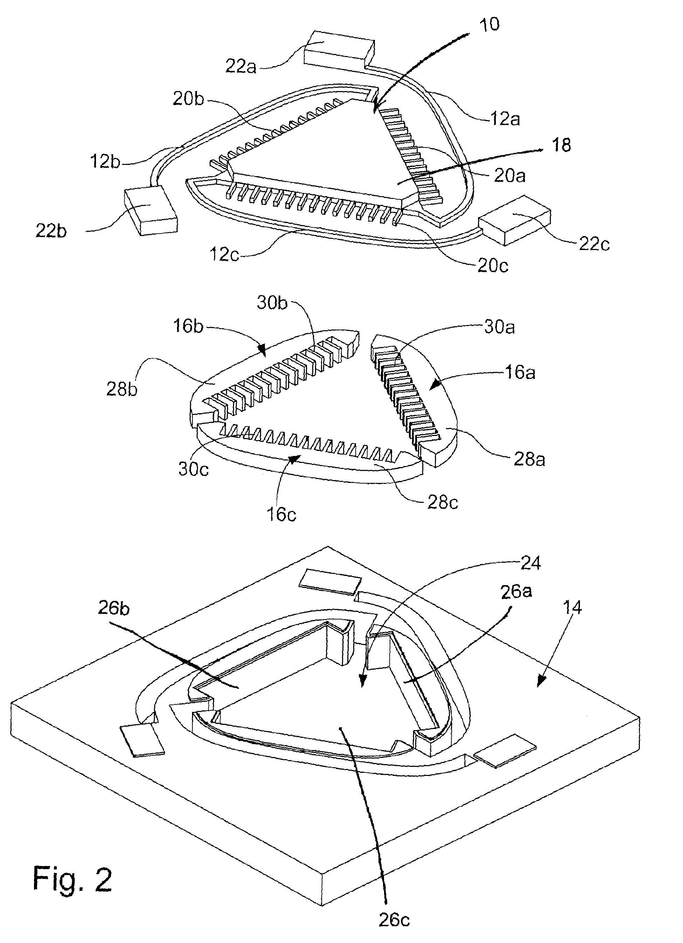

Le micro-actuateur illustré par les figures 1, 2 et 3 est réalisé par la technologie des MEMS à partir d'une plaquette de 'Silicon On Insulator' formée d'un substrat de silicium d'environ 300 microns d'épaisseur, d'une couche intermédiaire d'oxyde de 2 microns, et d'une couche supérieure de silicium de 50 microns. Il comporte un élément mobile 10 solidaire de trois poutres de suspension courbes 12a, 12b et 12c, ancrées sur une base fixe rigide 14, et trois électrodes fixes 16a, 16b et 16c solidaires de la base rigide 14.

L'élément mobile 10 peut, par exemple, former la partie optique du micro-actuateur, telle qu'un micro-miroir ou une micro-lentille, tandis que les électrodes 16a, 16b et 16c en constituent la commande. L'élément mobile 10, les trois poutres de suspension 12a, 12b et 12c ainsi que les trois électrodes 16a, 16b et 16c sont formés dans la couche supérieure de silicium et sont donc situés au même niveau, tandis que la base fixe 14 est formée dans le substrat. La couche d'oxyde interposée entre le substrat et la couche supérieure de silicium sert de couche isolante entre ledit substrat et les portions des éléments réalisés dans ladite couche supérieure de silicium.

L'élément mobile 10, formé dans la couche supérieure de silicium, est, dans l'exemple représenté, de forme triangulaire. Il va de soi que d'autres formes sont également possibles selon l'application envisagée. Cet élément 10 est obtenu par gravure ionique réactive profonde (Deep Reactive Ion Etching) de la couche supérieure de silicium, puis du substrat, comme explicité par la suite. Il possède une partie centrale 18, par exemple, de forme sensiblement triangulaire, dont les trois flancs sont munis de trois rangées de dents formant trois peignes 20a, 20b et 20c destinés à interagir avec les électrodes fixes 16a, 16b et 16c. Chacun des trois sommets de la partie centrale 18 est solidaire de l'une des extrémités d'une poutre de suspension 12a, 12b ou 12c, l'autre extrémité étant solidaire d'une ancre 22a, 22b ou 22c. Les ancres 22a, 22b et 22c sont, elles-mêmes, solidaires de la base fixe 14 et constituent les seuls points de contact entre l'ensemble formé par l'élément mobile 10, les poutres 12a, 12b et 12c et les ancres 22a, 22b et 22c, et la base fixe 14.

La partie centrale 18 de l'élément mobile 10 est d'épaisseur égale à celle de la couche supérieure de silicium, et le rapport de son épaisseur à ses dimensions latérales est tel qu'elle forme un élément rigide. Les trois peignes 20a, 20b et 20c ont, eux, une épaisseur qui est, environ, le tiers de l'épaisseur de la partie centrale 18, pour des raisons qui seront explicitées par la suite, et sont disposés au niveau du tiers inférieur des flancs de la partie centrale 18.

Chacune des poutres de suspension 12a, 12b et 12c s'enroule autour de l'élément mobile 10 en décrivant une courbe longeant l'un des côtés de l'élément mobile 10 qui lui est adjacent. Cette courbe, bien particulière, est représentée par la fonction mathématique suivante, choisie de façon à éviter la concentration de stress dans les poutres 12a, 12b et 12c :

$$y = (H/L).x - (H/\pi).\sin((\pi/L).x) \qquad (1)$$

Dans cette formule, H et L sont deux paramètres choisis en fonction des dimensions de l'actuateur et de la courbure souhaitée pour les poutres 12a, 12 b et 12c.

Bien entendu, d'autres courbes que celle décrite par l'équation ci-dessus sont également possibles pourvu qu'elles permettent de répondre aux exigences de grande flexibilité et de symétrie des suspensions, de non-transmission de stress à la partie mobile et de grande compacité de l'ensemble du micro-actuateur. Par ailleurs, une ligne polygonale peut être utilisée pour approximer une courbe choisie.

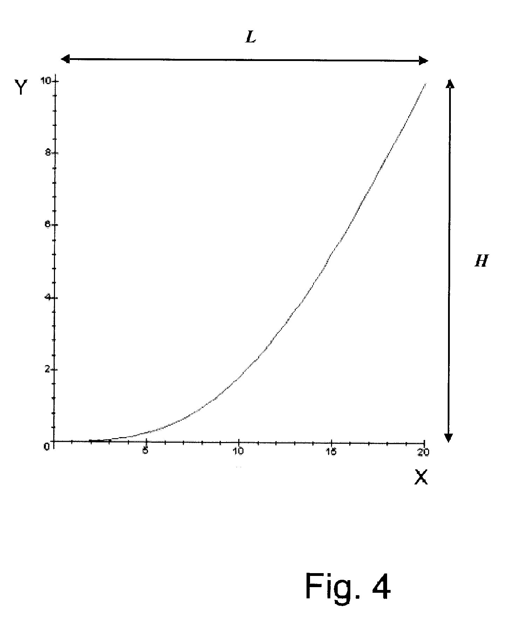

Pour une abscisse x comprise entre zéro et L, l'ordonnée y varie entre zéro et H, et la fonction (1) décrit une portion de courbe représentée en figure 4. La fonction est continûment différentiable en chaque point de cet intervalle et la courbe possède un rayon de courbure infini en ses deux extrémités. Ces caractéristiques évitent l'accumulation de stress en un point quelconque de la courbe et la mise bout à bout de deux de ces courbes conserve cette propriété. Ainsi, les poutres 12a, 12b et 12c peuvent être formées par un premier segment décrit par la fonction mathématique (1) définie dans l'intervalle compris entre zéro et L, et un deuxième segment obtenu par un retournement du premier au point x=L et Y=H.

Selon une variante et comme représenté à la figure 1, les deux segments décrits ci-dessus sont situés de part et d'autre d'un troisième segment rectiligne.

Outre l'avantage lié à l'absence de tensions dans de telles poutres, la disposition de ces dernières autour de l'élément mobile 10 assure une grande compacité du micro-actuateur. Par ailleurs, les poutres de suspension 12a, 12b et 12c ont une épaisseur d'environ un tiers de l'épaisseur de la couche supérieure de silicium. Elles sont donc longues en regard de leur section, ce qui leur confère une grande flexibilité.

La base rigide 14 constituée dans le substrat de la plaquette de SOI, de forme carrée ou rectangulaire, possède en son centre une ouverture 24 à symétrie triangulaire et traversant le substrat de silicium de part en part. Grâce à cette ouverture 24, le micro-actuateur peut travailler en transmission, par exemple l'élément mobile porte un élément optique, telle une lentille. De plus, plusieurs micro-actuateurs peuvent être disposés l'un au-dessus de l'autre pour réaliser des systèmes plus complexes, telle une cavité Fabry-Perot ajustable.

L'élément mobile 10 et les poutres de suspension 12a, 12b et 12c sont situés en regard de l'ouverture 24 pratiquée dans la base fixe 14, mais ne sont pas directement connectés au substrat. Les ancres 22a, 22b et 22c, qui sont solidaires de la base fixe 14 et assurent le rattachement de l'élément mobile 10 à la base fixe 14, par l'intermédiaire des poutres 12a, 12b et 12c, sont isolées du substrat grâce à la couche d'oxyde interposée entre le substrat et la couche supérieure de silicium.

Les trois électrodes statiques 16a, 16b et 16c formées dans la couche supérieure de silicium constituent trois peignes comportant un corps 28a, 28b et 28c et une rangée de dents 30a, 30b et 30c destinée à interagir respectivement avec les peignes 20a, 20b et 20c de la partie mobile 10. Les dents de ces peignes prennent place entre les dents des peignes 30a, 30b et 30c, sans les toucher. La couche d'oxyde interposée entre les corps 28a, 28b et 28c et le substrat assure l'isolation électrique des électrodes statiques 16a, 16b et 16c par rapport au substrat.

L'épaisseur des électrodes 16a, 16b et 16c est égale à celle de la couche supérieure de silicium, de sorte que les dents des peignes 20a, 20b et 20c, dont l'épaisseur ne représente qu'un tiers de la couche de silicium supérieure, se situent au niveau du tiers inférieur des dents des peignes 30a, 30b et 30c. La commande du micro-actuateur ainsi décrit est de type électrostatique. En raison de la disposition relative des dents des peignes 20a, 20b et 20c, et 30a, 30b et 30c, elle est dite asymétrique. En phase opérationnelle, l'élément mobile 10 et les poutres 12a, 12b et 12c sont connectés à la terre par l'intermédiaire des ancres 22a, 22b et 22c. Lorsqu'un potentiel est appliqué à l'une des électrodes 16a, 16b et 16c, la configuration asymétrique des peignes 20a, 20b et 20c, et 30a, 30b et 30c, crée un champ électrique lui-même asymétrique, ayant pour effet de générer une force tendant à corriger cette asymétrie. L'élément mobile 10 se déplace sous l'action de cette force jusqu'à ce que les forces mécaniques exercées par les poutres 12a, 12b et 12c équilibrent la force électrostatique. Le déplacement maximum de l'élément mobile 10 correspond à la configuration pour laquelle les dents des peigne 20a, 20b et 20c sont situées à mi-hauteur des dents des peignes 30a, 30b et 30c. Dans cette situation, la résultante des forces appliquées à l'élément mobile 10 est nulle.

En fonction du potentiel appliqué à chaque électrode, le mouvement effectué par la l'élément mobile 10 peut être purement de translation (perpendiculaire au plan du substrat), purement de bascule, ou combiné translation/bascule. Le mouvement de translation est obtenu lorsque le même potentiel est appliqué aux trois électrodes 16a, 16b et 16c, tandis que le mouvement combiné résulte d'une différence de potentiel entre au moins deux de ces électrodes 16.

Comme déjà mentionné, le micro-actuateur décrit est fabriqué à partir d'une plaquette de SOI. Le procédé de fabrication est le suivant. Un empilement de deux masques, le premier d'oxyde de silicium, le deuxième de photoresist, est appliqué en surface de la couche supérieure de silicium. Les surfaces exposées sont ensuite attaquées par gravure ionique réactive profonde. Lorsque l'épaisseur souhaitée des poutres 12a, 12b et 12c et des peignes 20a, 20b et 20c est atteinte, la gravure, est stoppée, le masque de photoresist est éliminé, puis la gravure est poursuivie avec le masque d'oxyde de silicium restant. Lorsque la gravure de la couche de silicium supérieure est terminée, une seconde étape de masquage est effectuée sur la partie arrière de la plaquette. L'ouverture 24 est réalisée par gravure ionique réactive profonde, de façon à libérer l'élément mobile 10 et les poutres 12a, 12b et 12c du substrat. Puis, la couche d'oxyde enterrée est attaquée et éliminée partout où elle est apparente.

Dans la description précédente, une commande de l'actuateur de type électrostatique a été présentée. Il va de soi que tout autre type de commande, par exemple de type magnétique, thermique ou acoustique, pourrait être employé en lieu et place de la commande électrostatique. Le principe de suspension de l'élément mobile et les mouvements effectués en seraient inchangés.

### Revendications

1. Micro-actuateur du type comportant un élément mobile (10) rattaché à une base fixe (14) par l'intermédiaire de poutres de suspension (12), et des moyens de commande (16) dudit élément mobile (10), **caractérisé en ce que**, afin d'éviter la concentration de stress dans lesdites poutres, celles-ci comportent au moins un segment courbe.

2. Micro-actuateur selon la revendication 1, **caractérisé en ce que** les poutres de suspension (12) entourent ledit élément mobile (10) et sont arrangées de manière symétrique dans le plan de ce dernier.

3. Micro-actuateur selon la revendication 1 ou la revendication 2, **caractérisé en ce que** les poutres de suspension (12) travaillent en flexion.

4. Micro-actuateur selon l'une des revendications 1 à 3, **caractérisé en ce que** ledit segment est décrit par une fonction mathématique définie sur un intervalle fini, continûment différentiable en chaque point dudit intervalle.

5. Micro-actuateur selon la revendication 4, **caractérisé en ce que** le rayon de courbure dudit segment est infini aux deux extrémités dudit intervalle.

6. Micro-actuateur selon l'une des revendications 1 à 5, **caractérisé en ce que** ladite fonction mathématique est définie par la formule :

$$y = (H/L).x - (H/\pi).\sin((\pi/L).x)$$

dans laquelle H et L sont deux paramètres choisis en fonction des dimensions dudit actuateur et de la courbure souhaitée pour lesdites poutres (12), ledit intervalle étant défini entre zéro et L.

7. Micro-actuateur selon l'une des revendications 1 à 6, **caractérisé en ce que** ledit élément mobile (10) est à symétrie centrale et lesdites poutres de suspension (12) sont au nombre de trois.

8. Micro-actuateur selon l'une des revendications 1 à 7, **caractérisé en ce que** chacune desdites poutres de suspension (12) est solidaire d'une ancre (22), elle-même solidaire de la base fixe (14).

9. Micro-actuateur selon l'une des revendications 1 à 8, **caractérisé en ce que** lesdits moyens de commande sont situés dans le même plan que l'élément mobile (10).

10. Micro-actuateur selon l'une des revendications 1 à 9, **caractérisé en ce que** lesdits moyens de commande sont des électrodes (16) formant des premiers peignes comportant un corps (28) et une rangée de dents (32).

**11.** Micro-actuateur selon la revendication 10, **caractérisé en ce que** ledit élément mobile (10) est formé d'une partie centrale (18) dont les flancs sont munis de dents formant des deuxièmes peignes (20) interagissant avec lesdits premiers peignes (16).

**12.** Micro-actuateur selon l'une des revendications 1 à 11, **caractérisé en ce que** ledit élément mobile (10) porte un élément d'optique.

**13.** Micro-actuateur selon l'une des revendications 1 à 12, **caractérisé en ce qu'**il est réalisé dans une plaquette comportant un substrat de silicium, et une mince couche d'oxyde interposée entre ledit substrat et une épaisse couche de silicium.

**14.** Micro-actuateur selon la revendication 13, **caractérisé en ce que** :

- ledit élément mobile (10), lesdites poutres de suspension (12), lesdites ancres (22) et lesdites électrodes (16) sont formés dans ladite couche de silicium,
- ladite base fixe (14) est formée dans ledit substrat de silicium, et
- ladite couche d'oxyde est interposée entre ledit substrat, d'une part, et lesdites électrodes et lesdites ancres, d'autre part.

Fig. 1

Fig. 3

Fig. 2

Fig. 4

**Office européen des brevets**

# RAPPORT DE RECHERCHE EUROPEENNE

Numéro de la demande

EP 05 10 6734

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | US 2004/258350 A1 (MILLER JOHN MICHAEL ET AL) 23 décembre 2004 (2004-12-23) | 1-5,9,12 | B81B3/00 |
| A | * alinéa [0053] * <br><br> * figure 11 * | 6-8,10, 11,13,14 | |
| X | WO 02/079853 A (CORNING INTELLISENSE CORPORATION; KUDRLE, THOMAS, DAVID; MASTRANGELO,) 10 octobre 2002 (2002-10-10) | 1-5,9,12 | |
| A | * page 11, ligne 12 - ligne 20 * <br> * figures 5a,5b * | 6 | |

DOMAINES TECHNIQUES RECHERCHES (Int.Cl.7)

B81B

Le présent rapport a été établi pour toutes les revendications

| Lieu de la recherche | Date d'achèvement de la recherche | Examinateur |
|---|---|---|
| Berlin | 1 novembre 2005 | Foussier, P |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 05 10 6734

La présente annexe indique les membres de la  famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre  indicatif et n'engagent pas la responsabilité  de l'Office européen des brevets.

01-11-2005

| Document brevet cité au rapport de recherche | Date de publication | Membre(s) de la famille de brevet(s) | Date de publication |
|---|---|---|---|
| US 2004258350    A1 | 23-12-2004 | AUCUN | |
| WO 02079853    A | 10-10-2002 | AUCUN | |

EPO FORM P0460